# EUROPEAN PATENT SPECIFICATION

(11) **EP 0 492 991 B1**
(45) Date of publication and mention of the grant of the patent: **23.06.1999**
(21) Application number: 91311810.5
(22) Date of filing: 19.12.1991
(51) Int. Cl.: H01L 21/336, H01L 29/78

(54) **Method of fabricating double diffused integrated MOSFET cells**
Verfahren zur Herstellung von doppelt-diffundierten integrierten MOSFET-Zellen
Procédé de fabrication de cellules du type MOSFET à double diffusion

(30) Priority: 21.12.1990 US 631573; 21.12.1990 US 631569
(43) Date of publication of application: 01.07.1992
(60) Divisional application: 98203152.8
(73) Proprietor: SILICONIX Incorporated, Santa Clara California 95054 (US)
(72) Inventor: Hshieh, Fwu-Iuan, San Jose, California 95129 (US); Chang, Mike, Cupertino, California 95014 (US); Yilmaz, Hamza, Saratoga, California 95070 (US)
(74) Representative: Jones, Ian

(56) References cited:
- EP-A- 0 279 403
- EP-A- 0 310 047
- EP-A- 0 405 205
- US-A- 4 620 211
- US-A- 4 803 532
- PATENT ABSTRACTS OF JAPAN, vol. 6, no. 205 (E-136)(1083), 16th October 1982; & JP-A-57 113 219 (FUJITSU K.K.) 14-07-1982
- SOLID STATE TECHNOLOGY, vol. 24, no. 7, July 1981, pages 44-51, Port Washington, NY, US; J.R. MONKOWSKI: "Gettering processes for defect control"

## Description

The present invention relates to integrated circuits and to the fabrication of such circuits, with particular reference to the fabrication of low defect DMOSFET structures.

Power MOSFET devices enjoy widespread use in such applications as automobile electrical systems, power supplies, and power management applications. Many such devices are commercially available, but an illustrative device is product number SMP60N05, available from Siliconix Incorporated, Santa Clara, California. This device is an N-channel enhancement mode transistor packaged in a TO-220AB case. The technology used to fabricate the SMP60N05 product is characterized by a specific on-resistance of 3.5 micro-ohms/cm2.

Many different processes have been used for the fabrication of power MOSFET devices over the years. These are generally deep diffusion processes. For example, in one early process disclosed in Great Britain Patent Application Publication No. 2 033 658 A, published May 21, 1980 and naming Lidow et al. as coinventors, a p+ tub region is about 4 microns deep and a p+ body region is about 3 microns deep. The cell configuration is hexagonal.

The technology used to fabricate the SMP60N05 product typically achieves junction depths range from 2.5 to 5 microns for the body, from 5 to 6 microns for the p+ body contact, and from 0.5 to 1 micron for the n+ source regions. The cell configuration is square.

The present invention facilitates the realization of a reduced r_{DS(on)} and a higher MOSFET cell density, which promotes more efficient load management switching and allows the use of smaller or no heat sinks. In another respect, the present invention facilitatcs the realization of a lower gate charge for the same specified on-resistance of earlier devices, which allows the use of small drive circuits and fewer components.

In accordance with the present invention, there is provided a method of forming an integrated circuit MOSFET cell in a silicon body of a first conductivity type comprising the steps of:
forming a first mask over the silicon body;
opening a first window in the first mask over a dopant-introduction site of the silicon body;
introducing dopant of a second conductivity type opposite to the first conductivity type through the first window and into the silicon body to form a lightly doped well of the second conductivity type aligned with the first window;
diffusing the lightly doped well laterally and outwardly from the first window;
introducing dopant of the second conductivity type through the first window and into the silicon body (146) to form a heavily doped region of the second conductivity type aligned with the first window such that the heavily doped region of the second conductivity type is located within the lightly doped well;
removing the first mask from the silicon body;
forming an insulated gate structure over the silicon body;
opening a second window in the insulated gate structure over the dopant-introduction site and also extending over material of the silicon body adjacent the dopant introduction site;
introducing dopant of the second conductivity type through the second window and into the silicon body to form a lightly doped region of the second conductivity type, the lightly doped region extending laterally beyond the lightly doped well and the heavily doped region of the second conductiity type and under the insulated gate structure;
masking a portion of the heavily doped region of the second conductivity type within the second window to form a third window; and
introducing dopant of the first conductivity type through the third window and into the silicon body to form a shallow heavily doped region of the first conductivity type aligned with the third window and located within the lightly doped well, the lightly doped region and the heavily doped region of the second conductivity type.

In one embodiment of the present invention, each corner of a double diffusion defining perimeter is greater than 120°.

The invention is further described below by way of example, with reference to the accompanying drawings, in which like reference numerals indicate like parts and in which:
Figure 1 is a schematic representation of a general n-channel power MOSFET with its simplified resistive equivalent circuit;
Figure 2 is a graph showing three voltage ratios;
Figure 3 is a plan view of a square cell;
Figure 4 is a cross sectional view of the square cell of Figure 3;
Figure 5 is a plan view of a square cell in accordance with the present invention;
Figure 6 is a cross-sectional view of the square cell of Figure 5;
Figure 7-17 show various stages in the fabrication of a device in accordance with the present invention;
Figure 18 is a cross-sectional view of the periphery of a pwer MOSFET device in accordance with the present invention; and
Figures 19-20 are plan views of a completed power MOSFET device, in accordance with the present invention.

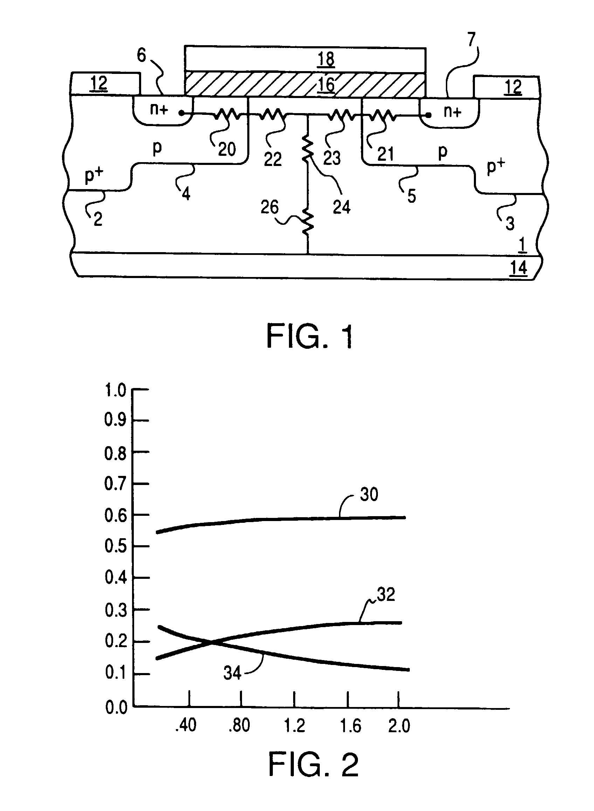

A cross-sectional structure of an n-channel power MOSFET with its simplified resistive equivalent circuit is illustrated in Figure 1. A n-type lightly doped epitaxial silicon layer 1 includes various diffused regions such as the deep p+ regions 2 and 3, p body regions 4 and 5, and n+ source regions 6 and 7. A typically continuous source-body electrode 12 extends across certain surface portions of the epitaxial layer 1. A drain electrode 14 is provided at the backside of the n+ doped substrate (not separately shown). An insulated gate structure comprising gate oxide 16 and polysilicon 18 is provided over the drain and portions of the body, the latter functioning as MOSFET channel regions. The principal elements of the simplified resistive circuit include the channel resistances 20 and 21, the JFET resistance 22, 23 and 24, and the epi resistance 26.

Figure 2 is a graph showing the on-resistance contribution of the channel regions 20 and 21, the JFET region 22, 23 and 24, and the epi region 26 for an arbitrary 60 volt n-channel DMOSFET. V_{GS} is 10 volts, temperature is 25 degrees C, each square cell measures 10 microns by 10 microns, and the cell space is 6 microns. Curve 30 represents the ratio of the channel resistance 20 to R_{DS}, curve 32 represents the ratio of the JFET resistance 24 to R_{DS}, and curve 34 represents the ratio of the epi resistance 26 to R_{DS}. As is apparent, on-resistance is dominated by the channel resistance 20 and 21, the JFET resistance 24 is generally of secondary significance, and the epi resistance 26 is generally of tertiary significance.

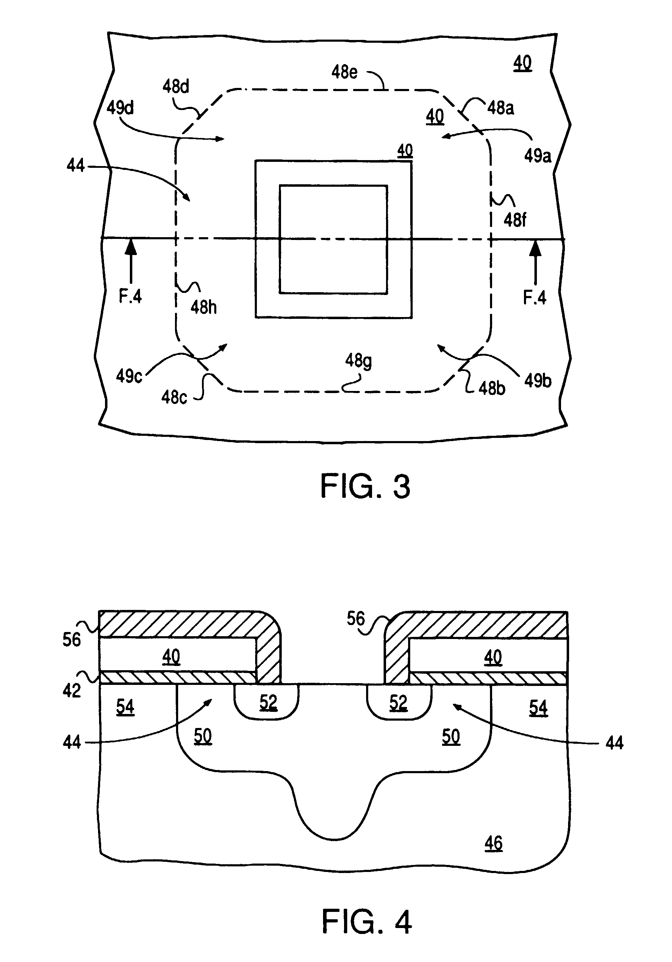

We have discovered that the use of a modified square cell in conjunction with shallow p body, p tub, and p+ diffusions results in reduced channel resistance 20 and 21 and reduced JFET resistance 24 while avoiding punch-through due to three dimensional effects at the cell corners. A typical square cell such as used in the previously mentioned product number SMP60N05 is shown in Figures 3 and 4, prior to metallization. The edge of the polysilicon gate 40, which overlays gate oxide 42, is used in the double diffusion process to define the channel 44. The channel lies within p body region 50, between source region 52 and drain region 54 in the epitaxial layer 46. Typically, the channel length for the square cells of any given device is in the range of from about 1.5 microns to about 4 microns, reflecting the comparatively deep drive-in used to form the variously doped epitaxial regions described above. The polysilicon gate 40 is covered with a layer of oxide 56. EP-A-0 279 402 shows a typical square cell.

An effect known as the three dimensional diffusion phenomenon generally does not cause too much of a problem in the cell of Figures 3 and 4, although it is evident in the plan view of Figure 3. The first diffusion of the double diffusion process, which is described in detail below, is a rather lightly p-type diffusion which is strongly driven in to a depth of from 2.5 microns to 5 microns. Generally, p-type dopant diffuses horizontally at a rate of about 80 percent of vertical diffusion. Due to the spreading effect in the corners, the effective rate of horizontal diffusion is much less, on the order of merely 50 percent. The result is that diffusion does not advance as far at the corners of the square cell as it does along linear segments, which is seen by comparing corner segments 48a, 48b, 48c and 48d of the body-drain junction with the mediate linear segments 48e, 48f, 48g and 48h. While the effect also occurs with n-type material, it is much less severe than the effect seen with the p-type material. The reason is because the n-diffusion, the second diffusion in the double diffusion process, is a rather heavy n+ type diffusion to a comparatively shallow depth on the order of from 0.5 to 1 micron. Moreover, n-type material tends to diffuse to about the same extent horizontally as vertically. The result is that the dopant advance at the corners is not noticeably impeded, relative to the extent that the advance of the p-type material is impeded, as suggested by regions 49a, 49b, 49c and 49d. While the channel 44 does tend to be shorter at the corners, the cell is still useful.

Were the channel 44 to be made generally short, the three dimensional diffusion effect likely would result in punch-through at the corners. Punch-through is a condition in which the depletion region reaches into the n+ source, thereby causing conductance through the reverse-biased device and leading to device breakdown. Punch-through would occur because the three dimensional diffusion effect would cause the channel 44 to be excessively short at the corners 48a, 48b, 48c and 48d.

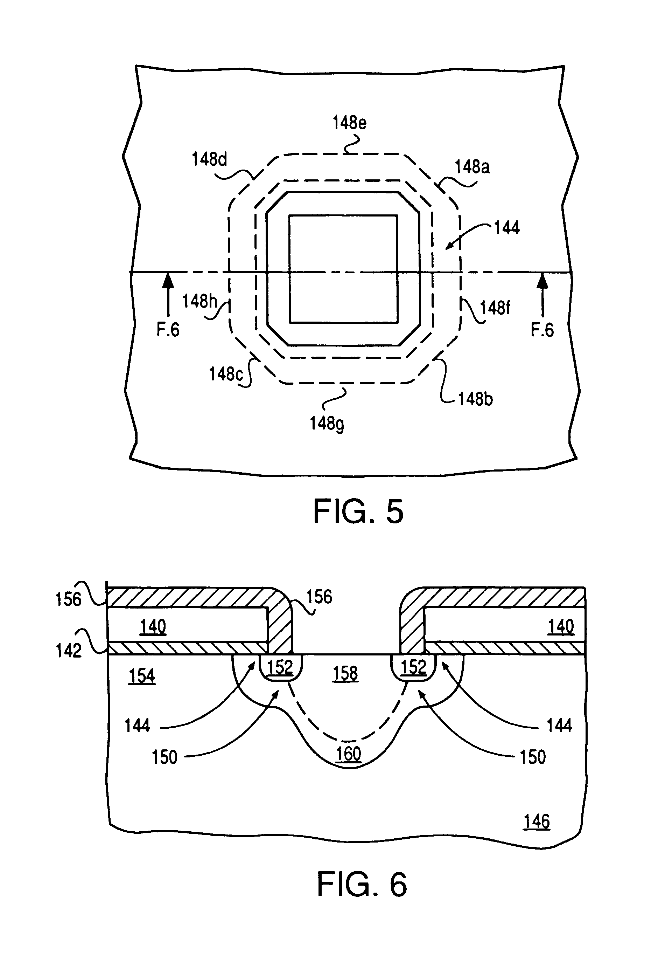

In the cell of Figures 5 and 6, excessive shortening of the channel 144 in the corner regions 148a, 148b, 148c and 148d is avoided by making the sharp corner blunt. In the square cell of Figures 5 and 6, the corners are advantageously made blunt by replacing the 90 degree corner angle in the polysilicon 140 with a short linear segment that makes a 135 degree angle with both contiguous linear segments. For example, segment 148a makes a 135 degree angle with segments 148e and 148f; segment 148b makes a 135 degree angle with segments 148f and 148g; segment 148c makes a 135 degree angle with segments 148g and 148h; and segment 148d makes a 135 degree angle with segments 148h and 148e. As the three dimensional effect is rendered less problematic at the critical corners, the diffusions are kept shallow and the length of channel 144 brought into the range of from 0.5 to 0.75 microns, for example. Typical junction depths in this event would be about 2.5 - 3 microns for the p-tub 160, about 2 - 2.5 microns for the p+ body contact 158, about 1 - 1.25 microns for the p body 150, and about 0.3 - 0.6 microns for the n+ source region 152. Note that normally a heavily doped shallow region such as p+ body contact 158 would lower the breakdown voltage by up to 40 percent compared to earlier devices built on the same epi specifications (doping and thickness). This difficulty is overcome in accordance with the present invention by providing the lightly doped p- tub 160, which forms a linearly graded pn junction, resulting in improved breakdown voltage.

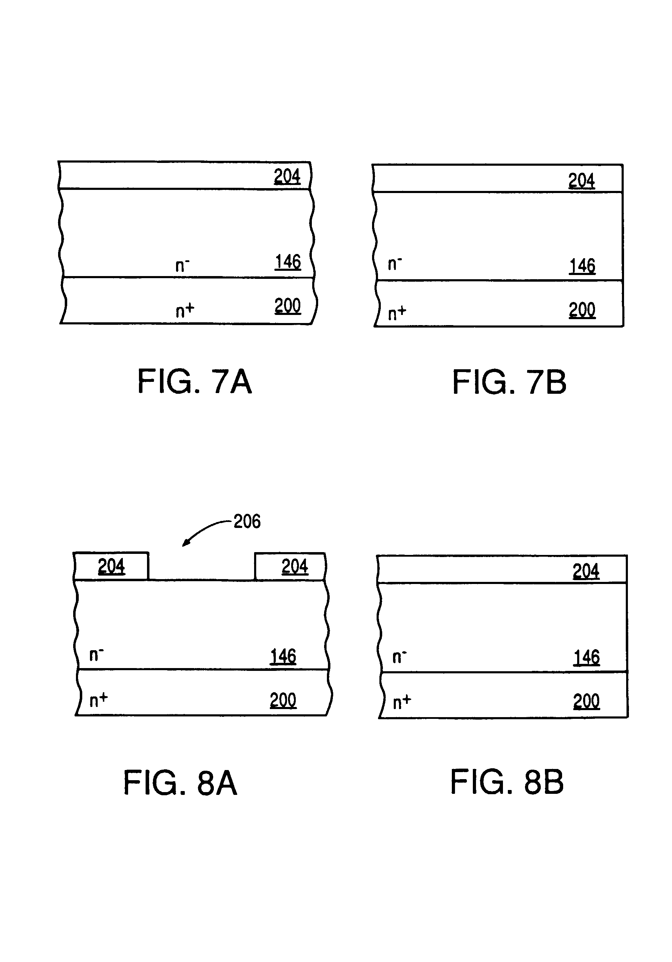

The process for forming the cell of Figures 5 and 6 is illustrated in Figures 7-17. Part A of Figures 7-17 are cross-sectional views taken through a typical cell, while part B of Figures 7-17 are cross-sectional views taken through the termination region at the periphery of the chip.

Suitable starting material includes a n+ doped silicon substrate 200 having a resistivity in the range of, for example, from 0.001 to 0.005 ohm-cm, supporting a n- doped epitaxial layer 146 having a resistivity of, for example, from 0.15 to 1 ohm-cm. A thermally grown field oxide 204 is grown by any suitable process such as, for example, a thermal process to a thickness in the range of, for example, 5000 to 10,000 Angstroms, as shown in Figure 7.

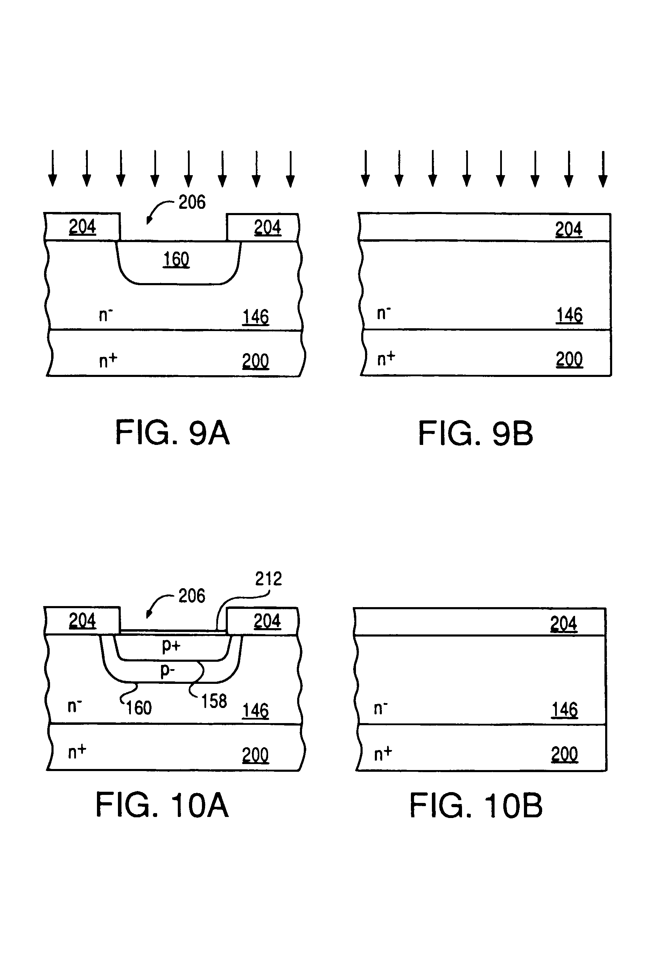

The first masking step is for the diffusion of the p- tub and the p+ body contact. A window 206 is opened in the field oxide 204 over the cell region by any suitable process such as, for example, a dry oxide etch. The resist is suitably stripped, and the p- tub implant is made (Figure 9) with Boron at a dose in the range of 1E13 - 1E14 /cm2, at a power in the range of 40 - 100 KeV. The Boron implant is diffused at a temperature of from 1000 to 1250 degrees C for from 2-10 hours using any suitable oven to form the p- tub 160. A wet etch in a suitable HF solution is carried out to remove any resulting oxide, and the p+ body contact is formed by injecting Boron from a boron nitride source in any suitable furnace through the window 206 at 750 - 1000 degrees C. A Boron rich glass 212 forms in the window 206 during the injection. A Boron soak is carried out in any suitable oven at 750 - 1000 degrees C for from 15 minutes to 3 hours, as appropriate, wherein boron from the glass continues to diffuse into the epitaxial silicon to form p+ body contact 158 in the p- tub 160 (Figure 10). The sheet resistance of the p+ body contact is 10 - 100 ohm/square.

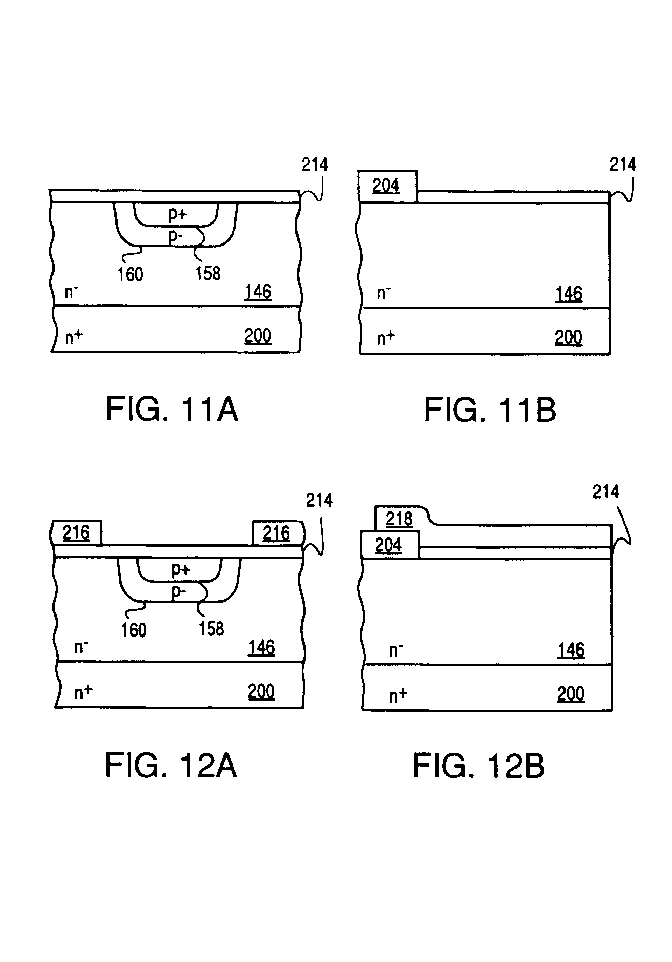

In a second masking step, the field oxide 204 is protected in the peripheral termination region, including gate finger regions. All oxide is removed from the active device areas, and gate oxide 214 is thermally grown at 900 -1100 degrees C for from 20 minutes to 3 hours, as desired (Figure 11).

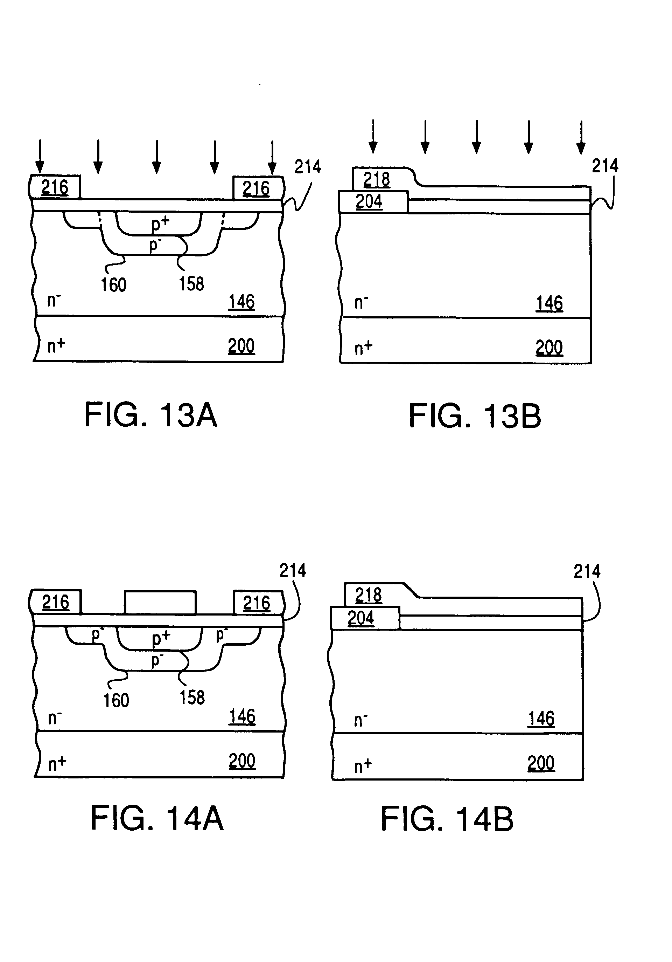

A polysilicon film is deposited to a thickness of 0.3 -0.7 microns using any suitable equipment. A polysilicon film also is deposited on the backside, and is removed along with an underlying oxide in a wet oxide etch for the purpose of exposing the wafer backside to heavy diffusion using phosphorus or other suitable dopant. The polysilicon film is then doped to less than about 20 ohm/square, and is patterned in a third masking step for opening windows to form p- body, n+ source regions, and ultimately metal contacts to the source and body. The polysilicon film is etched in any suitable equipment, to form gate poly 216 and periphery strip 218, a component of a termination structure. The resist is stripped, and Boron is implanted at a dose of 5E13 - 2E14 /cm2 and a power of 40 - 100 KeV in any suitable equipment (Figure 13). The Boron is diffused at 900 - 1200 degrees C for 10 minutes to 5 hours, as desired. The purpose of this diffusion is to form the double diffused channel 144.

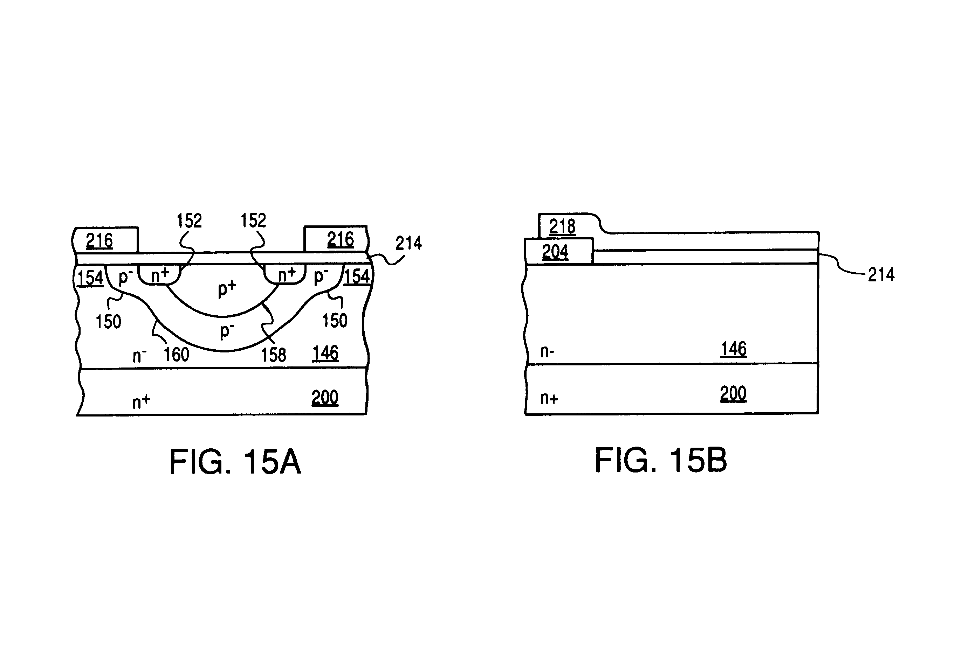

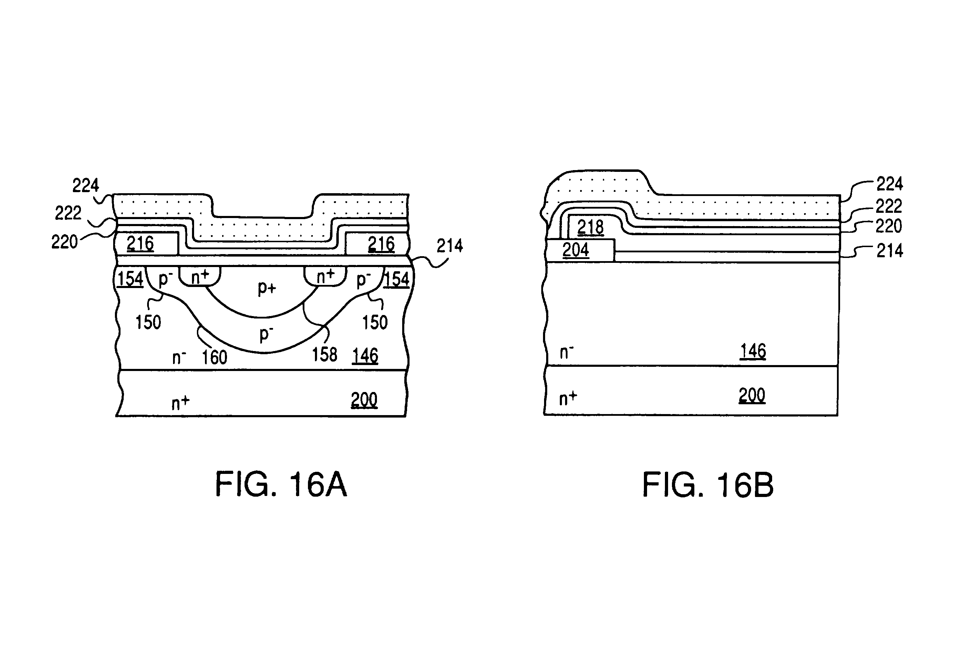

Oxide is etched from the p- body diffusion region using either a dry or wet etch, as desired, and a layer of suitable photoresist is deposited and patterned in a fourth masking step to form a body contact mask (Figure 14). An Arsenic implant is made using a dose of 1E15 - 1E16 /cm2 at a power of 60 - 120KeV, after which the resist is stripped (Figure 15) and the Arsenic diffused at 850 - 1100 degrees C for 0.5 - 1 hour to form the square source region 152. An oxide layer 220 forms during the Arsenic diffusion (Figure 16). The square channel 144 is defined in the body 158, between the square source region 152 and the drain 154. At this point, the junction profile of the cell is essentially established.

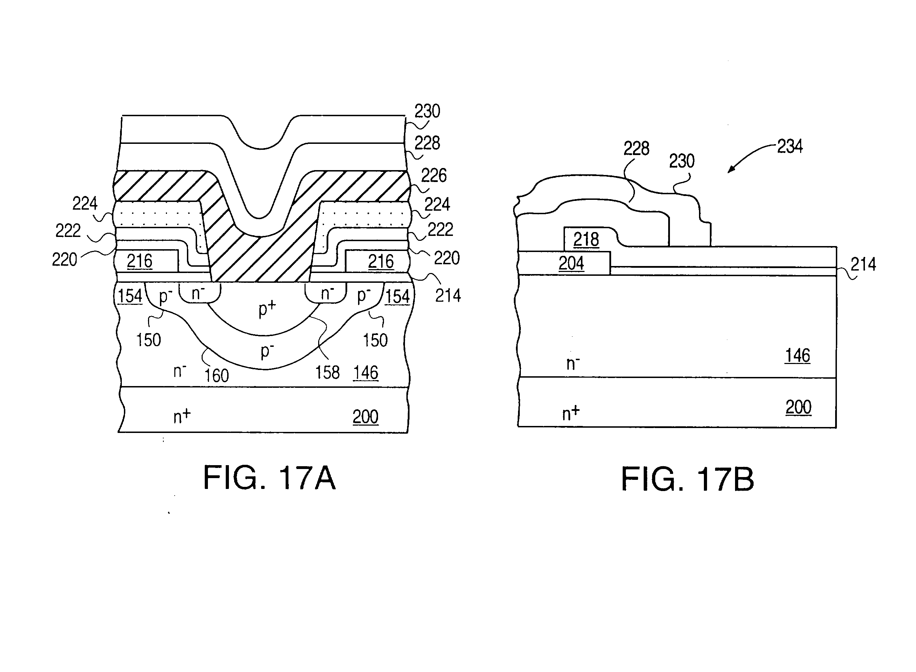

The device is completed by depositing (optionally) about 1000 Angstroms of LPCVD nitride 222 followed by a BPSG deposition of about 0.8 - 1.3 microns and a BPSG reflow 224 at about 850 - 1000 degrees C (Figure 16). The fifth masking step is a contact mask, which defines the source-body contact and the poly gate contact. The BPSG layer 224, the nitride layer 222, and the oxide layer 220 are suitably etched in a sequence involving, for example, a descum, a dry etch in suitable equipment, and a resist strip, followed by a reflow of the BPSG at 850 - 1100 degrees C for 10 - 30 minutes (Figure 17). A suitable metal such as aluminum or a material such as aluminum with 1 percent silicon is deposited using, for example, sputter deposition, and is suitably patterned in a sixth masking step and etched to form the source electrode 226, the gate electrode (not shown), and termination field plates (not shown). Films of PSG 228 and/or plasma nitride 230 are deposited, pad contact holes are opened in a seventh masking step, and an alloy step is performed at 300 - 450 degrees C in an inert ambient.

The termination structure 234 comprising field oxide 204, gate oxide 214, and polysilicon periphery strip 218 need only be coupled electrostaticly to the epitaxial silicon 146 in order to function satisfactorily. The coupling is achieved when the die is separated from the wafer by dicing, since the thin gate oxide 214 near the die edge is damaged and becomes leaky. The termination structure 234 assumes the voltage level of the epitaxial layer 146, and at this potential acts to exclude the depletion region from the leaky damaged silicon at the die edge.

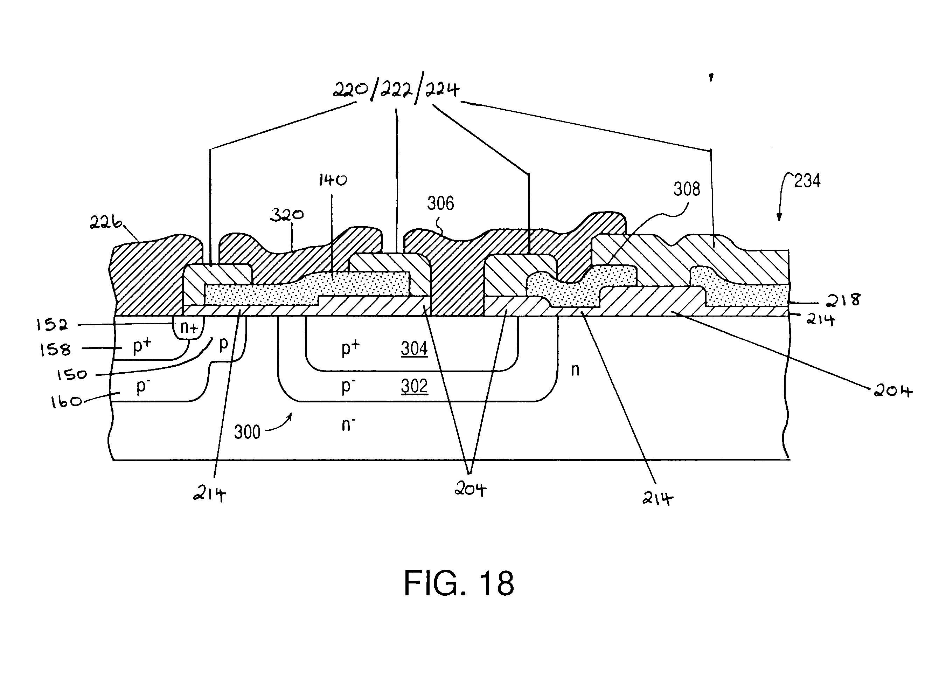

Figure 18 shows the full termination structure, including a typical inactive cell 300. The inactive cell 300 is similar to the active cells except no channel region is provided, although a p- tub 302 and p+ body contact 304 are provided. Source metal 306 shorts a polysilicon ring 308 and the inactive cell 300 to the source electrode. Note the termination structure 234.

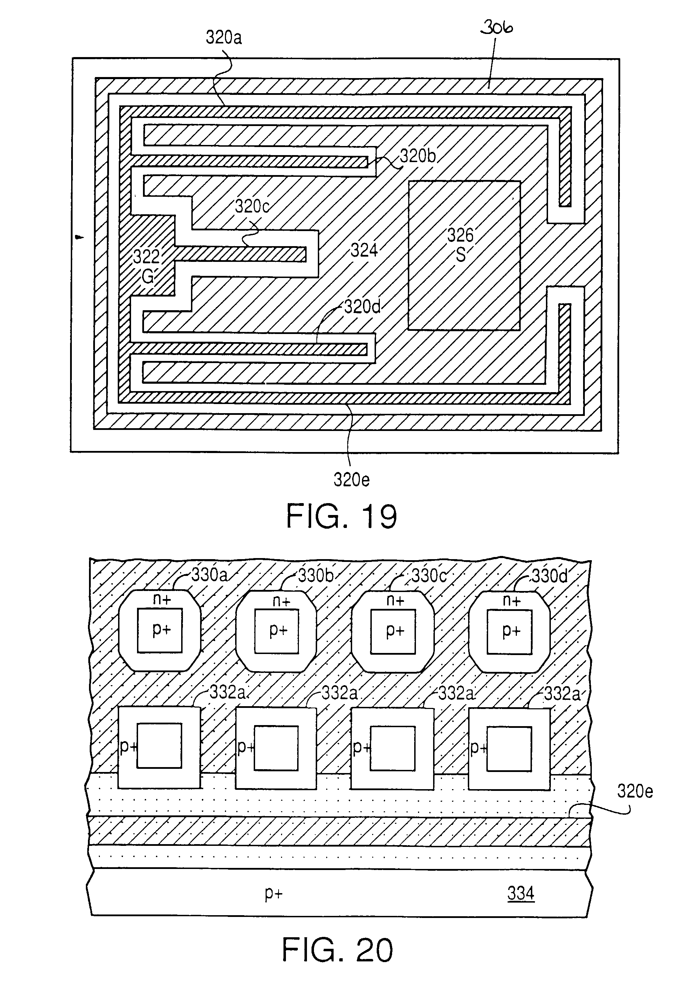

Figure 19 shows a plan view of a completed device with the gate fingers 320a-320e, gate bonding pad 322, source metal 324, and source bonding pad 326. The exploded view of Figure 20 shows the juxtaposition of the active cells 330a-330d (other active cells in the device are not shown), the inactive cells 332a-332d (other inactive cells in the device are not shown), the gate finger 320e, and the p+ polysilicon ring 334.

We also have discovered that the use of certain techniques in the process of forming the modified square cell having shallow p body, p tub, p+ and n+ diffusions achieves short channels while avoiding junction leakage due to silicon defects. While suitable starting material includes phosphorus and arsenic doped silicon, arsenic doped silicon achieves better intrinsic gettering. Polysilicon is deposited on the backside for extrinsic gettering.

TCA or trichloroethane is incorporated in the process gases for most of the temperature treatment to control silicon defect forementioned. The percentage of TCA in the ambient has to be optimized, and too much TCA will result in silicon pitting due to HCl etching and the carbon-induced defects. For each temperature treatment, begin at 750 degrees C and ramp up to final temperature, which under some circumstances is 1250 degrees C.

Prior to initial oxidation with steam, TCA gettering at high temperature provides intrinsic gettering and furnace cleaning for oxide quality improvement and stacking fault reduction. TCA in the range of 1 - 6 percent at a temperature in the range of 1000 - 1250 degrees C is suitable.

Prior to p- tub diffusion, TCA gettering at high temperature anneals implant defects in silicon and reduces stacking fault formation.

The three step Boron process for the p+ body contact, which involves Boron injection, Boron soak, and low temperature oxidation in the range discussed above avoids fatal defects and achieves a low sheet resistance as discussed above.

In the process sequence for forming the thin gate oxide, TCA gettering with minimizing carbon contamination achieves oxide rupture voltage enhancement and minimize defect formation. A suitable TCA concentration is in the range of 0.5 - 5 percent at a temperature in the range of 900 - 1100 degrees C is required to optimize the process since too much TCA will induce carbon-related defects, as explained above.

In the process sequence for the p- body diffusion, TCA gettering with high temperature anneal implantation damage achieves silicon defect reduction. A suitable TCA concentration is 0.5 - 5 percent at a temperature in the range of 900 - 1200 degrees C to gain optimized process that will satisfy the shallow junction requirements and without suffering defect loss.

In the process sequence for source diffusion, a high temperature anneal before reoxidation in TCA/02 ambient achieves silicon defect reduction. A suitable TCA concentration is 0.5 - 5 percent at a temperature in the range of 850 - 1100 degrees C.

In the process sequence for dry etch after BPSG reflow, the silicon is slightly etched to eliminate auto doping from the BPSG during reflow. This minimizes the contact resistance variation.

These techniques have been used to achieve a specific on-resistance of 1.65 milliohms-cm2 for 60 volt devices, and 0.85 milliohms-cm2 for 30 volt devices.

While our invention has been described with respect to the embodiments set forth above, our invention is not to be considered limited thereto. For example, no particular equipment type is critical. Moreover, the ranges given for the process parameters are illustrative, and not intended to be limiting per se.

## Claims

1. A method of forming an integrated circuit MOSFET cell in a silicon body (146) of a first conductivity type comprising the steps of:
forming a first mask over the silicon body (146);
opening a first window in the first mask over a dopant-introduction site of the silicon body (146);
introducing dopant of a second conductivity type opposite to the first conductivity type through the first window and into the silicon body (146) to form a lightly doped well (160) of the second conductivity type aligned with the first window;
diffusing the lightly doped well (160) laterally and outwardly from the first window;
introducing dopant of the second conductivity type through the first window and into the silicon body (146) to form a heavily doped region (158) of the second conductivity type aligned with the first window such that the heavily doped region (158) of the second conductivity type is located within the lightly doped well (160);
removing the first mask from the silicon body;
forming an insulated gate structure (140, 142; 214, 216) over the silicon body (146);
opening a second window in the insulated gate structure (140 142;214,216) ver the dopant-introduction site and also extending over material of the silicon body (146) adjacent the dopant introduction site;
introducing dopant of the second conductivity type through the second window and into the silicon body (146) to form a lightly doped region (150) of the second conductivity type, the lightly doped region extending laterally beyond the lightly doped well (160) and the heavily doped region (158) of the second conductivity type and under the insulated gate structure (140, 142; 214, 216);
masking a portion of the heavily doped region (158) of the second conductivity type within the second window to form a third window; and
introducing dopant of the first conductivity type through the third window and into the silicon body to form a shallow heavily doped region (152) of the first conductivity type aligned with the third window and located within the lightly doped well, the lightly doped region and the heavily doped region of the second conductivity type.

2. A method as in Claim 1, wherein all angles in the second window are no less than approximately 120°.

3. A method as in Claim 1, wherein the step of forming the heavily doped region (158) of the second conductivity type comprises forming a glass rich in a dopant of the second conductivity type on the silicon body (146) in the first window and diffusing dopant from the dopant rich glass into the lightly doped well (160).

4. A method as in Claim 1, wherein the lightly doped well (160) extends into the silicon body (146) to a greater depth than the heavily doped region (158) of the second conductivity type and the lightly doped region (150).

5. A method as in Claim 1, wherein the lightly doped well (160) separates the heavily doped region of the second conductivity type from the remainder of the silicon body (146).

6. A method as claimed in Claim 1, wherein the first window extends through the first mask, and the second window extends through the insulated gate structure (140, 142; 214, 216).

## Patentansprüche

1. Verfahren zur Herstellung einer MOSFET-Zelle in einer integrierten Schaltung in einem Siliciumkörper (146) eines ersten Leitfähigkeitstyps, umfassend die folgenden Schritte:
Bilden einer ersten Maske über dem Siliciumkörper (146);
Öffnen eines ersten Fensters in der ersten Maske über einem Dotierungseinführungsort des Siliciumkörpers (146);
Einführen eines Dotierungsmittels eines zweiten Leitfähigkeitstyps, der dem ersten Leitfähigkeitstyp entgegengesetzt ist, durch das erste Fenster und in den Siliciumkörper (146), um eine leicht dotierte Mulde (160) des zweiten Leitfähigkeitstyps zu bilden, die auf das erste Fenster justiert ist;
Diffundieren der leicht dotierten Mulde (160) seitlich und außerhalb des ersten Fensters;
Einführen eines Dotierungsmittels des zweiten Leitfähigkeitstyps durch das erste Fenster und in den Siliciumkörper (146) zur Bildung einer stark dotierten Zone (158) des zweiten Leitfähigkeitstyps, die auf das erste Fenster justiert ist, so daß sich die stark dotierte Zone (158) des zweiten Leitfähigkeitstyps in der leicht dotierten Mulde (160) befindet;
Entfernen der ersten Maske von dem Siliciumkörper;
Ausbilden einer isolierten Gatestruktur (140, 142; 214, 216) über dem Siliciumkörper (146);
Öffnen eines zweiten Fensters in der isolierten Gatestruktur (140, 142; 214, 216) über dem Dotierungseinführungsort, das sich auch über Material des Siliciumkörpers (146) neben dem Dotierungseinführungsort erstreckt;
Einführen von Dotierungsmittel des zweiten Leitfähigkeitstyps durch das zweite Fenster und in den Siliciumkörper (146), um eine leicht dotierte Zone (150) des zweiten Leitfähigkeitstyps zu bilden, wobei die leicht dotierte Zone seitlich über die leicht dotierte Mulde (160) und die stark dotierte Zone (158) des zweiten Leitfähigkeitstyps hinaus und unter der isolierten Gatestruktur (140, 142; 214, 216) verläuft;
Maskieren eines Abschnitts der stark dotierten Zone (158) des zweiten Leitfähigkeitstyps in dem zweiten Fenster zur Bildung eines dritten Fensters; und
Einführen eines Dotierungsmittels des ersten Leitfähigkeitstyps durch das dritte Fenster und in den Siliciumkörper zur Bildung einer flachen, stark dotierten Zone (152) des ersten Leitfähigkeitstyps, die auf das dritte Fenster justiert ist und sich in der leicht dotierten Mulde, der leicht dotierten Zone und der stark dotierten Zone des zweiten Leitfähigkeitstyps befindet.

2. Verfahren nach Anspruch 1, bei dem alle Winkel in dem zweiten Fenster wenigstens etwa 120° betragen.

3. Verfahren nach Anspruch 1, bei dem der Schritt des Ausbildens der schwer dotierten Zone (158) des zweiten Leitfähigkeitstyps folgendes umfaßt: Bilden eines Glases, das reich an Dotierungsmittel des zweiten Leitfähigkeitstyps auf dem Siliciumkörper (146) in dem ersten Fenster ist, und Diffundieren von Dotierungsmittel von dem dotierungsmittelreichen Glas in die leicht dotierte Mulde (160).

4. Verfahren nach Anspruch 1, bei dem die leicht dotierte Mulde (160) bis zu einer größeren Tiefe in den Siliciumkörper (146) verläuft als die stark dotierte Zone (158) des zweiten Leitfähigkeitstyps und die leicht dotierte Zone (150).

5. Verfahren nach Anspruch 1, bei dem die leicht dotierte Mulde (160) die stark dotierte Zone des zweiten Leitfähigkeitstyps vom Rest des Siliciumkörpers (146) trennt.

6. Verfahren nach Anspruch 1, bei dem das erste Fenster durch die erste Maske verläuft und das zweite Fenster durch die isolierte Gatestruktur (140, 142; 214, 216) verläuft.

## Revendications

1. Un procédé de formation d'une cellule d'un transistor MOS à effet de champ à circuits intégrés dans un corps en silicium (146) d'un premier type de conductivité, comportant les étapes suivantes :
formation d'un premier masque au-dessus du corps en silicium (146) ;
ouverture d'une première fenêtre dans le premier masque au-dessus d'un point d'introduction de dopant du corps en silicium (146) ;
introduction de dopant d'un second type de conductivité opposé au premier type de conductivité à travers la première fenêtre et dans le corps en silicium (146) pour former un puits légèrement dopé (160) du second type de conductivité aligné avec la première fenêtre ;
diffusion du puits légèrement dopé (160) latéralement et vers l'extérieur de la première fenêtre ;
introduction de dopant du second type de conductivité à travers la première fenêtre et dans le corps en silicium (146) pour former une zone fortement dopée (158) du second type de conductivité, alignée avec la première fenêtre de façon telle que la zone fortement dopée (158) du second type de conductivité est située à l'intérieur du puits légèrement dopé (160) ;
enlèvement du premier masque du corps en silicium ;
formation d'une structure à grille isolée (140,142 ; 214,216) au-dessus du corps en silicium (146) ;
ouverture d'une seconde fenêtre dans la structure à grille isolée (140,142 ; 214,216) au-dessus du point d'introduction de dopant et s'étendant également au-dessus du matériau du corps en silicium (146) adjacent au point d'introduction de dopant ;
introduction de dopant du second type de conductivité à travers la seconde fenêtre et dans le corps en silicium (146) pour former une zone légèrement dopée (150) du second type de conductivité, la zone légèrement dopée s'étendant latéralement au-delà du puits légèrement dopé (160) et de la zone fortement dopée (158) du second type de conductivité et sous la structure à grille isolée (140,142 ; 214,216) ;
masquage d'une portion de la zone fortement dopée (158) du second type de conductivité à l'intérieur de la seconde fenêtre pour former une troisième fenêtre ; et
introduction de dopant du premier type de conductivité à travers la troisième fenêtre et dans le corps en silicium pour former une zone fortement dopée peu profonde (152) du premier type de conductivité alignée avec la troisième fenêtre et placée à l'intérieur du puits légèrement dopé, de la zone légèrement dopée et de la zone fortement dopée du second type de conductivité.

2. Un procédé selon la Revendication 1, selon lequel tous les angles dans la seconde fenêtre mesurent au moins 120° environ.

3. Un procédé selon la Revendication 1, selon lequel l'étape de formation de la zone fortement dopée (158) du second type de conductivité comporte la formation d'un verre riche en un dopant du second type de conductivité sur le corps en silicium (146) dans la première fenêtre, et la diffusion du dopant à partir du verre riche en dopant dans le puits légèrement dopé (160).

4. Un procédé selon la Revendication 1, selon lequel le puits légèrement dopé (160) s'étend dans le corps en silicium (146) jusqu'à une profondeur plus grande que la zone fortement dopée (158) du second type de conductivitié et que la zone légèrement dopée (150).

5. Un procédé selon la Revendication 1, selon lequel le puits légèrement dopé (160) sépare la zone fortement dopée du second type de conductivité du reste du corps en silicium (146).

6. Un procédé selon la Revendication 1, selon lequel la première fenêtre s'étend à travers le premier masque, et la seconde fenêtre s'étend à travers la structure à grille isolée (140,142 ; 214,216).
